# EUROPEAN PATENT APPLICATION

(11) **EP 0 525 297 A2**
(43) Date of publication of application: **03.02.1993**
(21) Application number: 92105125.6
(22) Date of filing: 25.03.1992
(51) Int. Cl.: H01L 21/203, H01L 21/331, H01L 21/205, C30B 25/02

(54) **Method of growing doped crystal**

(30) Priority: 08.05.1991 JP 102777/91
(71) Applicant: FUJITSU LIMITED, Kawasaki-shi, Kanagawa 211 (JP)
(72) Inventor: Sandhu, Adarsh, c/o Fujitsu Limited, Kawasaki-shi, Kanagawa 211 (JP)
(74) Representative: Seeger, Wolfgang, Dipl.-Phys.

(57) **Abstract**

An impurity-doped compound semiconductor layer with a high carrier concentration can be easily grown with a high controllability by a gas source molecular beam epitaxy process, the process comprising growing a first layer of a compound semiconductor (e.g., a III-V compound semiconductor) by supplying gas sources for elements of the compound semiconductor in a vacuum atmosphere without doping an impurity in the first layer, forming a second layer containing an impurity by supplying the gas sources and a gas source for the impurity (e.g., disilane), but stopping at least one source of the gas sources (e.g., a III group source) to stop the growing of the compound semiconductor, in a vacuum atmosphere, repeating the formation of the first and second layers to thereby form layers which function as an equivalent of a single impurity-doped compound semiconductor layer (e.g., a Si-doped III-V compound semiconductor).

## Description

### BACKGROUND OF THE INVENTION

### 1. Field of the Invention

This invention relates to gas phase crystal growth, particularly to a gas source molecular beam epitaxy (GSMBE) by which an epitaxial layer doped with an impurity is grown by using gaseous source materials.

GSMBE is attracting increasing attention as a method of growing single crystals of III-V compound semiconductors. GSMBE has the properties of both compound semiconductors grown by solid source molecular beam epitaxy and the ease of controlling gas phase source materials in the metalorganic chemical vapor deposition (MOCVD), thereby enabling the formation of a heterojunction structure of a compound semiconductor while controlling the thickness of the atomic layer, and has properties suitable for mass production growth of a homogeneous epitaxial layer on a plurality of substrate crystals. GSMBE is particularly suitable for growing a heterostructure of a mixed crystal semiconductor, for example, the growth of a lattice - matched InGaAs layer on an InP substrate, etc.

### 2. Description of the Related Art

The following, description is made with reference to an example of the epitaxial growth of a III-V semiconductor, but is not limited thereto.

As the gas phase crystal growth method of III- V group compound semiconductors, there are known in the prior art the molecular beam epitaxy (MBE) method in which a solid phase source is employed and a molecular beam in a high vacuum is employed, and the metalorganic chemical vapor deposition (MOCVD) method in which an organic metal is used as the starting material and grown by flowing the source gas onto a base substrate heated under a relatively higher pressure, such as atmospheric pressure (760m Torr).

In the MBE method, the epitaxial growth is performed by impirging a molecular beam under a pressure of about 10-² to 10-⁴ Pa (back pressure of about 10-⁸ Pa) onto a base crystal, whereby the film thickness on the atomic layer order can be easily controlled. The source material is fed in a particulate form. Nevertheless, the MBE method has a disadvantage in that defects are liable to be formed in the crystal layer.

In the MOCVD method, these gas phase sources of metalorganic compounds or hydrides are fed as a viscous flow under a relatively higher pressure, such as the atmospheric pressure, and the molecules pyrolyzed on the surface of the base substrate or the vicinity thereof grow epitaxially, thus providing a controllability and productivity suitable for a mass production. Nevertheless, the MOCVD method has drawbacks such that the control or film thickness on the atomic layer order, as in the MBE method cannot be made, that it is uneconomical because of the large amount of the source gases that must be used, or that it is disadvantageous in the case of a toxic gas such as AsH₃, etc.

In this connection, the GSMBE method improves the controllability of the source materials, by using metalorganic compounds and metal hydrides as the source materials as in the MOCVD method, and enables a control of the film thickness to a high precision by using high vacuum (e.g., an the order of 10-³ to 10-⁴ Torr) as the crystal growth atmosphere, as in the MBE method. For example, triethylgallium (TEG, Ga(C₂H₅)₃) is employed as the group III source material and arsine (AsH₃) as the group V source material, for a growth of GaAs.

In the GSMBE method, if a solid phase impurity dopant source (Be or Si) is employed, as in the prior art, for the growth of a doped III-V compound semiconductor, the reproducibility thereof becomes difficult. This is because a reaction occurs between the impurity dopant atom heated to 1000^{*}C or higher and the metalorganic gas or decomposed products, resulting in a lowering of the doping efficiency. This problem is solved by using a gaseous impurity dopant source such as trimethylgal- lium (p-type) or disilane (amphoteric).

In the GSMBE method, however, a problem arises even if a gaseous impurity dopant source is employed. Namely, in the GSMBE method, when a gas phase impurity source is added, the growth rate of a compound semiconductor is influenced by the gaseous impurity dopant source. This effect is not constant but is complicated, and the growth rate is not constant when varying the amount of the gaseous impurity dopant source added to thereby change the doped amount, and it is difficult to obtain the desired composition in a ternary system compound semiconductor. This problem may be considered to be unique to the GSMBE method.

### SUMMARY OF THE INVENTION

An object of the present invention is to develop a gas source molecular beam epitaxial crystal growth method by which a crystal doped with an impurity dopant can be grown with good controllability and repodusibility.

According to the present invention, the above objective is attained by providing a method for epitaxially growing a compound semiconductor layer on a substrate by gas source molecular beam epitaxy (GSMBE), comprising the steps of growing a first layer of a compound semiconductor by supplying gas sources for elements of the compound semiconductor in a vacuum atmosphere without doping an impurity in the first layer, forming a second layer containing an impurity by supplying said gas sources and a gas source for said impurity but stopping at least one source of said gas sources to stop the growth of said compound semiconductor, in a vacuum atmosphere, repeating the formation of said first and second layers to thereby form layers which function as an equivalent of a single impurity-doped compound semiconductor layer.

In a preferred embodiment of the present invention, there is also provided a method of epitaxially growing a III-V compound semiconductor layer on a substrate by gas source molecular beam epitaxy (GSMBE), comprising the steps of growing a first layer of a III-V compound semiconductor by supplying gas sources for III and V group elements of the compound semiconductor in a vacuum atmosphere without doping an impurity in the first layer, forming a second layer containing an impurity by supplying said gas sources for V group elements and a gas source for said impurity, but stopping said gas sources for III group elements to stop the growth of said compound semiconductor, in a vacuum atmosphere, repeating the formation of said first and second layers to thereby form layers which function as an equivalent of a single n-type impurity-doped III-V compound semiconductor layer.

The present invention is particularly advantageous when a compound semiconductor to be grown is composed of not less than three elements.

Typically, the first layer has a thickness of up to 100 nm, preferably up to 50 nm, and the second layer has an effective thickness of at least 3 nm and less than that of the first layer.

In accordance with the present invention, a carrier concentration of more than 5 x 10¹⁸ cm-³ and a doping efficiency of more than 90%, close to 100%, for example, in the grown impurity-doped III- V compound semiconductor layer as a whole can be obtained.

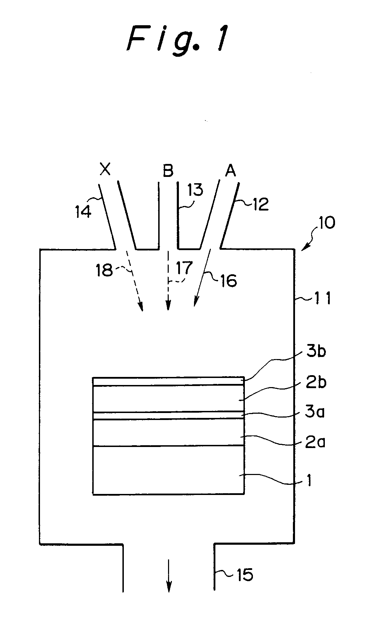

The principle of the present invention is described with reference to Fig. 1, wherein the GSMBE apparatus 10 is provided with a vacuum chamber 11, source feeding ports 12, 13, 14 connected to the vacuum chamber 11, and an evacuation system port 15. A base crystal 1 is arranged in the vacuum chamber 11, and the layers 2a, 2b --- not doped with an impurity and the layers 3a, 3b --- formed by an dopant impurity are grown repeatedly on the base crystal 1.

By alternately forming the non-doped layers 2a, 2b --- and the layers due to the dopant gas 3a, 3b ---, the growth conditions can be made free of any influence of impurity during the crystal growth of the layers 2a, 2b --- not doped with an impurity. Also the layers 3a, 3b --- due to the impurity can be given functions corresponding to various impurity concentrations, by growing the crystals under constant conditions. Further, by making the film thickness of the layers 2a, 2b --- not doped with an impurity sufficiently small, a region in which layers not doped with an impurity and layers doped with an impurity are alternately laminated functions as a whole, similar to a region doped with an impurity, through a solid phase diffusion of the impurity atoms and tunnelling of the carriers.

### BRIEF DESCRIPTION OF THE DRAWINGS

Fig. 1 illustrates the principle of the present invention;
Fig. 2 is a graph showing the relationship between the disilane flow rate and the GaAs growth rate in GSMBE;
Fig. 3 is a schematic sectional view of the constitution of the GSMBE apparatus to be used in an embodiment of the present invention;
Fig. 4 illustrates the growth of the epitaxial layer doped with the n-type impurity according to the embodiment of the present invention, in which (A) is a schematic sectional view showing the constitution of the grown crystal, and (B), (C) and (D) are graphs showing the molecular beam dose changes of the epitaxial growth starting materials;
Fig. 5 shows the layer structure and the Si concentration in the case of a multi-layer planar doping of Si into GaAs in the embodiment;
Fig. 6 is a graph showing the relationship between the Si concentration and the carrier concentration in the case of the doping in Fig. 5;
Fig. 7 illustrates the epitaxial growth doped with a dopant impurity according to another embodiment of the present invention, in which (A) is a schematic sectional view showing the constitution of the grown crystal, and (B), (C) and (D) are graphs showing the molecular beam supplies of the starting materials for the epitaxial growth; and,
Fig. 8 shows the structure of the bipolar transistor of the embodiment of the present invention.

### DESCRIPTION OF THE PREFERRED EMBODIMENTS

Before describing the embodiments of the present invention, the use of a gaseous dopant impurity source in the GSMBE method is described with reference to a specific embodiment thereof.

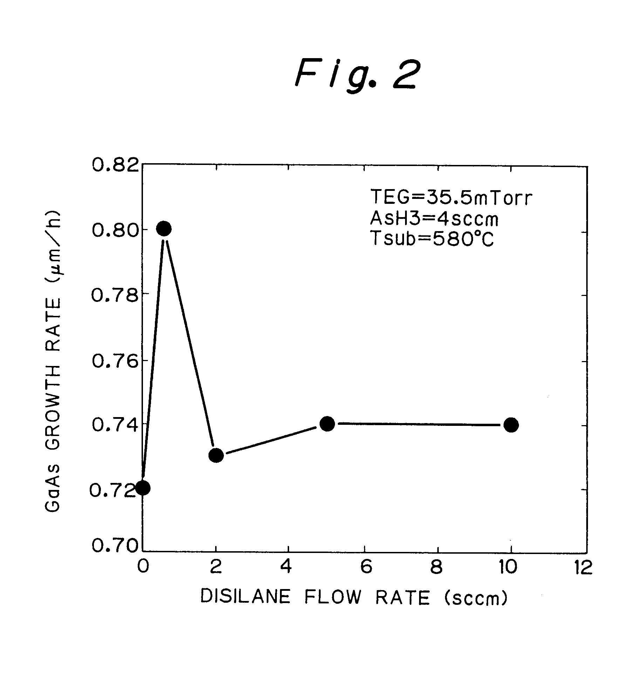

Figure 2 shows the change in the growth rate of GaAs when using disilane (Sb H₆) as the doping impurity source and varying the flow rate of disilane when carrying out an epitaxial growth of gallium arsenide (GaAs) by flowing trimetylgallium (TMG) as the gallium source at 35.5 mTorr and arsine (AsH₃) as the arsenic source at 4 sccm at a substrate temperature of 580 °C, in the GSMBE method. As seen from the Figure, the GaAs growth rate changes are complicated and make prediction of the growth rate difficult. Also, when the binary system such as GaAs is changed to a compound semiconductor of ternary system such as AIGaAs, not only the growth rate but also the composition of the grown crystal changes are complicated, in line with the flow rate of disilane, and it is very difficult to determine the flow rates of the respective sources, to thereby obtain a desired composition and doped quantities of the impurities.

The present inventors consider that the cause of this phenomenon is as follows.

In the GSMBE method, source for elements are fed in the form of compounds, and generate decomposed products during the crystal growth. For example, when a metalorganic compound is decomposed, organic substances such as ethyl and methyl, etc., will be generated in addition to the desired metal elements, and when a hydride is decomposed, hydrogen will be generated. If, while growing a mixed crystal, the source materials are fed after determining the ratio of source materials for the component elements, the desired composition can be obtained. For example, to grow a lattice-matched InGaAs on a substrate of InP, preferably the composition ratio is In : Ga=0.53 : 0.47. The flow rates of the respective source gases, etc., are controlled to thus obtain this composition.

In the GSMBE method, however, when an impurity is to be doped, decomposed products also will be generated from the source gases of the impurity, resulting in a fluctuation of the growth conditions. For example, when disilane (Si₂Hs) is fed as the impurity source for doping Si as the impurity into a group III-V compound semiconductor, hydrogen will be generated as the decomposed product, and the crystal growth mechanism will be influenced by the amount of hydrogen generated. For example, when growing a mixed crystal, the composition of the mixed crystal will be changed. Such an influence is not constant but is very complicated.

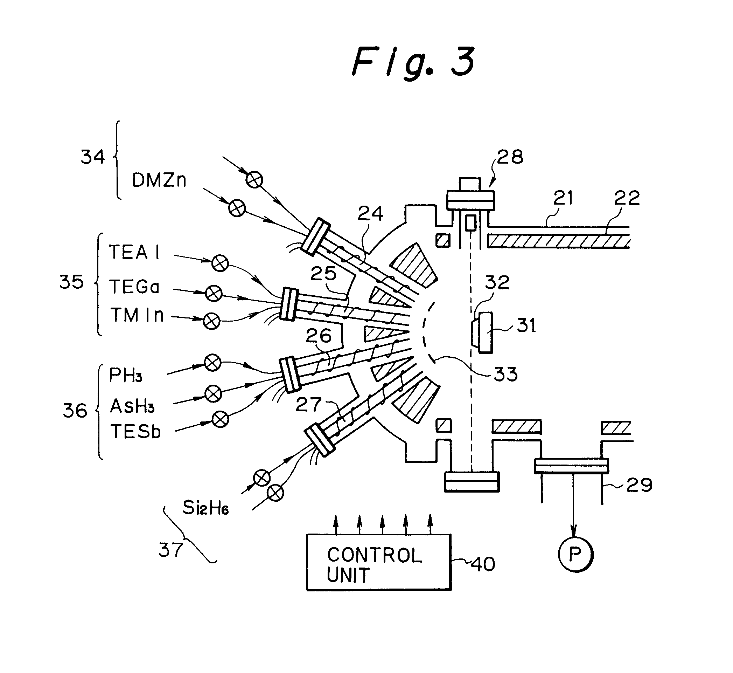

Figure 3 is a schematic view of the constitution of the GSMBE apparatus to be used in the embodiments of the present invention.

The vacuum chamber 21 is provided with source gas feeding ports, ports for measuring devices, and a gas evacuation duct 29, and further, a shroud 22 cooled with liquid nitrogen, for an adsorption of impurity gases, is arranged on an inner wall thereof. A plurality of molecular beam supply sources 24 to 27, connected to the desired gas phase sources, are arranged in the source gas feeding ports. For example, the molecular beam supply source 24 is connected to a source 34 of an organic compound of a group II element, the molecular beam supply source 25 to a source 35 of a metalorganic compound 35 of a group III element, the molecular beam supply source 26 to sources 36 of hydrides of a group V elements and a metalorganic compound, and the molecular beam supply source 27 to a source 37 of an impurity.

In the constitution shown, a reflection type high energy electron beam diffraction (RHEED) apparatus is provided by using the two measuring ports for a monitoring of the crystal growth. A susceptor 31, which can be heated, and on which is mounted a base substrate 32, is arranged at the central portion of the vacuum chamber 21.

For example, a good crystal can be grown when GaAs is grown by using triethylgallium (TEGa) as the group III starting material 35 and arsine (AsH₃) as the group V starting material 36. These source gases can be controlled through the control device 40.

When growing a layer doped with an impurity, the impurity gas 37 is controlled to be fed intermittently.

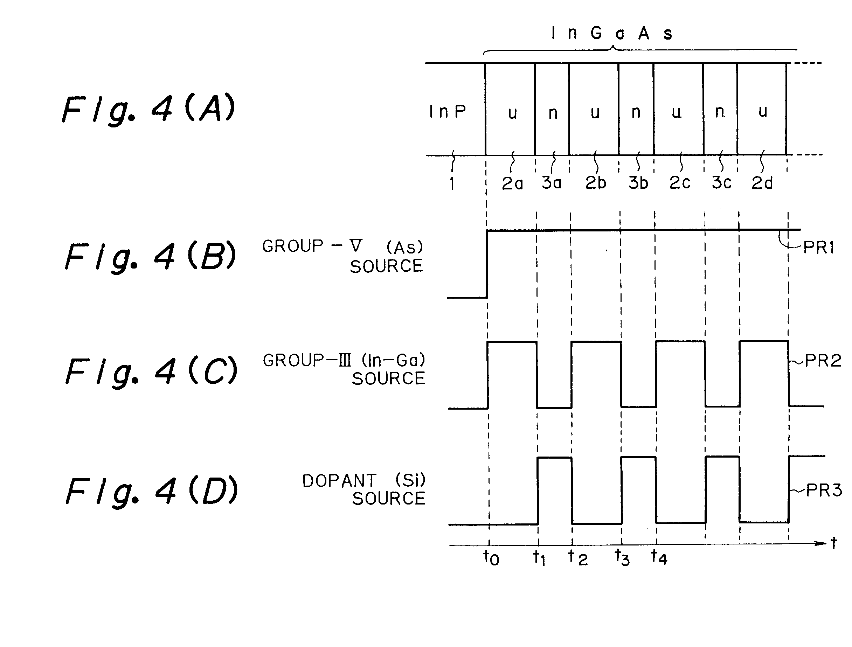

Figure 4 shows the crystal growth of the epitaxial layer doped with an impurity according to the embodiment of the present invention. In Fig. 4, (A) is a sectional schematic view of the constitution of the grown crystal. As shown, on InP base crystal 1 are alternately grown an InGaAs layer 2a not doped with impurity, a layer 3a formed due to an n-type impurity, and InGaAs layers 2b, 2c, 2d .. not doped with impurity, and n-type layers 3b, 3c, .. formed due to an n-type impurity.

The layers 2a, 2b, 2c, --- not doped with impurity can be grown by a conventional GSMBE method, and the composition and growth rate, etc., thereof can be controlled with a high precision. The extent to which the impurity is doped also can be controlled by either the flow rate of the impurity gas, the time for which the impurity gas is allowed to flow, or the thickness of the layer not doped with the impurity. Therefore, the layers 3a, 3b, 3c, .. formed due to impurity dopant gas also can be formed under controlled conditions. By making the ratio of the layers 2a, 2b, 2c, .. not doped with the impurity to the layers,3a, 3b, 3c, .. due to the impurity dopant gas a desired value, layers as a whole having a function similar to an epitaxial layer having a desired impurity concentration can be realized. In this case, it is necessary to grow the layers 2a, 2b, 2c, .. not doped with an impurity to a thickness thinner than a predetermined thickness. When the layers 2a, 2b, 2c, .. not doped with an impurity are sufficiently thin, it can be considered that a uniform layer as a whole is formed by a solid phase diffusion of the impurity atoms from the layers 3a, 3b, 3c, .. formed due the impurity dopant gas and a tunneling of the carriers passing through the layers 2a, 2b, 2c, .. not doped with the impurity.

In Figs. 4, (B), (C), and (D) show the control of the starting material gases used for carrying out the epitaxial growth as shown in (A). (B) is a schematic view of the feeding of arsine (AsH₃), the starting material for As of the group V elements. PR1 shows the molecular beam flux of arsine.

(C) is a schematic view of the feeding of the starting materials for the group III elements (In, Ga). PR2 is a schematic view of the molecular beam flux of the group III starting materials (TEGa and TMln) as a whole.

(D) is a schematic view of the molecular beam flux PR3 of the starting material (disilane) for the group IV element Si, which is the impurity.

In the figure, the abscissa indicates the time and the ordinate indicates the intersity of molecular beam flux.

At the time t=to, the flux PR1 of the group V starting material and the molecular beam supply PR2 of the group III starting materials are on, and the crystal growth of the III-V group compound semiconductor begins. At the time t=t₁, the molecular beam supply PR2 of the group III starting material is made zero, and instead, the molecular beam supply PR3 of the impurity starting material is on. This state continues up to the time t=t₂, and the group V starting material is fed continually. Between the times t=t₁ and t=t₂, since the group V starting material and the impurity starting material are fed, the group IV element generated from the impurity starting material occupies the site of the group III element, and the group IV element functions as a donor.

Between the times t=t₂ and t=t₃, the feeding of the impurity starting material is stopped, and instead, the group III starting materials are fed. Therefore, during this time, a growth of the III-V group compound semiconductor not doped with the impurity is effected, i.e., an undoped crystal is grown.

During the time t=t₃ and t=t₄, the feeding of the group III starting materials is stopped, and instead, the group IV element, which is the impurity starting material, is fed. The group V starting material is still continually fed, and therefore, the group IV element occupies the site of the group III element, to function as the donor element.

As desribed above, the group V starting material is fed continually, while the group III starting materials and the group IV starting material for the impurity are fed alternately, whereby the group IV starting material occupies the site of the group III element to function as the n-type impurity.

Thus, as shown in (A) of Fig. 4, the layers 2a, 2b, 2c, .. not doped with the impurity and the n-type layers 3a, 3b, 3c, .. formed due to the impurity are grown and formed, alternately.

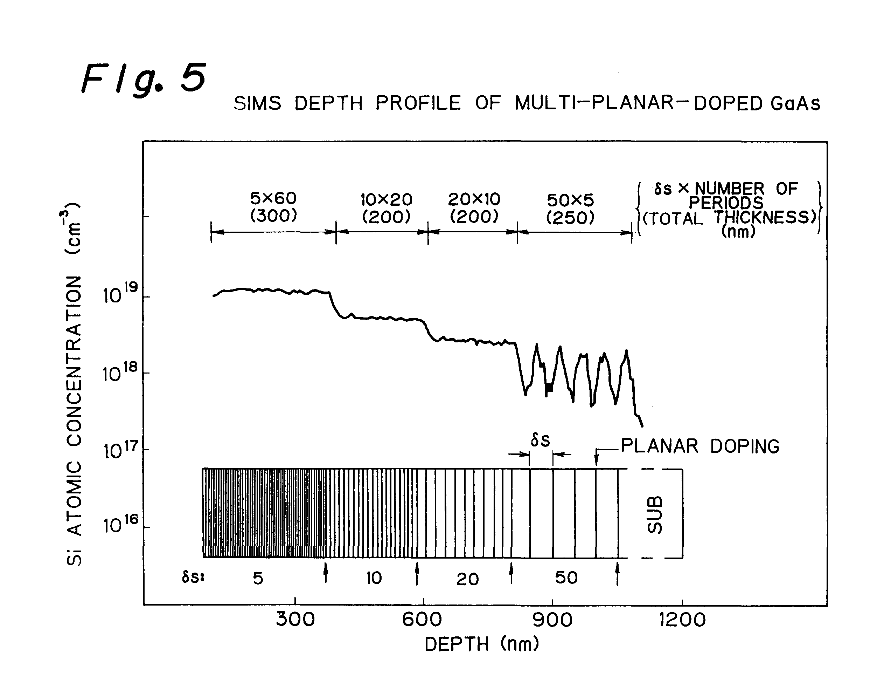

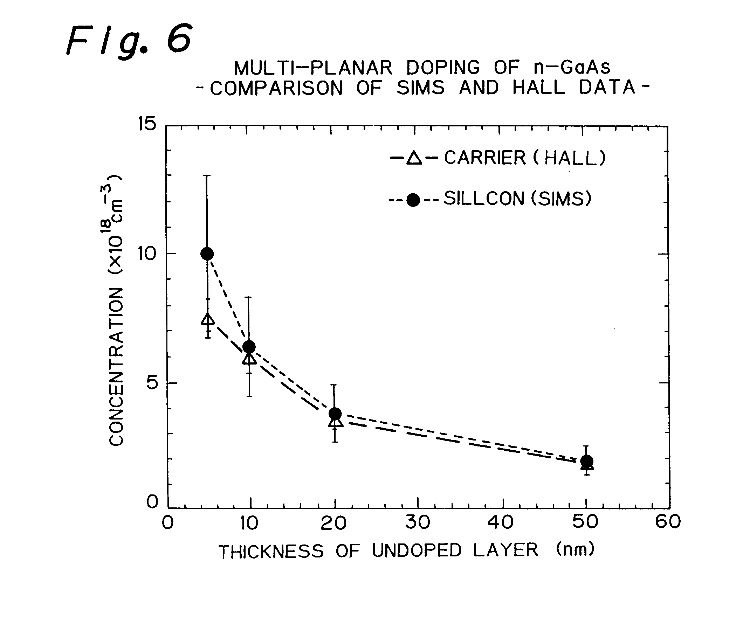

Fig. 5 and Fig. 6 show the characteristic data of a multi-layer planar doped GaAs epictaxial layer when growing undoped GaAs layers under the above-mentioned GaAs growth conditions in the GSMBE method, i.e., TEG 35.5mTorr, AsH₃ 4 sccm, the substrate temperature 580 C, and stopping the feeding of TEG and feeding Si2 H6 at 10 sccm to dope Si as the impurity, wherein the thickness of the undoped GaAs layer is varied from 5 nm to 50 nm, while the thickness of the Si layer is made constant at 6 nm.

The specific operating procedures are as described below.
(1) TEG, AsH₃ are fed to grow GaAs.
(2) Feeding of TEG (group III source) stopped.
(3) After stopping the growth for 2 seconds, Si2 H6 is fed for 60 seconds.
(4) Feeding of Si2 H6 stopped. In 2 seconds, residual Si2 H6 is reduced to a negligible extent.
(5) TEG reintroduced to grow the undoped GaAs to a predetermined film thickness.
(6) By repeating the above operations (2) to (5), an epitaxial layer with a desired thickness is grown.

As shown in Fig. 5, the desired thickness of the epitaxial layer is made 250 nm, 200 nm, 200 nm, 300 nm, respectively, when the thickness of the undoped GaAs layer is 50 nm, 20 nm, 10 nm, and 5 nm, respectively.

The lower diagram within the frame in Fig. 5 is a schematic constitutional diagram of the epitaxial layers, and the upper diagram shows the data of the Si concentration in the epitaxial layers measured using secondary 10r mass spectroscopy (SIMS).

Figure 6 is a graph showing the values of the carrier concentration in the epitaxial layers measured electrically, and the average Si concentration in the respective epitaxial layers in relation to the thickness of the undoped GaAs layer in the respective epitaxial layers.

It can be seen from Fig. 6, that the carrier concentrations in the respective epitaxial layers coincide well with the Si concentrations, within the error range.

This reveals that the multi-layer planar doping method is effective as the doping method and has a very high impurity doping efficiency-of substantially 100%. When feeding the impurity source simultaneously with the group III source and the group V source according to the method of the prior art, the carrier concentration obtained is only 3 x 10¹⁸ cm-³ at highest, even if the impurity concentration is made as high as possible, and the doping efficiency of the impurity is lowered with the increase of the amount of the impurity added, and therefore, the method of the present invention has the effects of an improved impurity doping efficiency and an improved dopable carrier concentration.

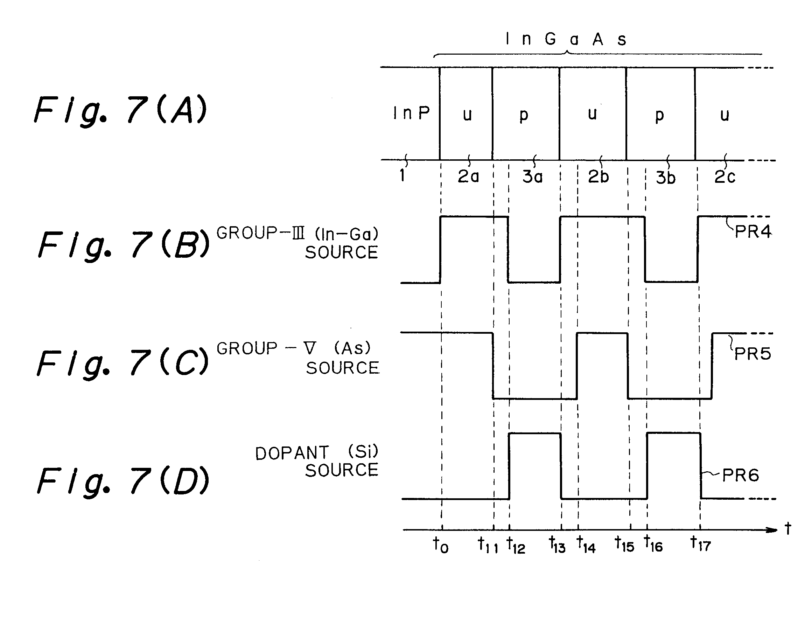

Figure 7 shows the method of growing a crystal doped with a p-type impurity according to another embodiment of the present invention. In Fig. 7, (A) is a schematic view of the constitution of the grown crystal. The InGaAs layers 2a, 2b, 2c, .. not doped with the impurity and the layers 3a, 3b, .. formed due to the p-type gaseous impurity source are grown and formed alternately on the InP base crystal 1.

Thus, by alternately laminating the layers not doped with the impurity and the layers due to the gaseous impurity source and controlling the thickness of the layers not doped with the impurity, a function equal to a layer doped with an impurity is exhibited as a whole.

In Fig. 7, (B), (C) and (D) are schematic views of a control of the starting material molecular source fluxes for growing the epitaxial layers shown in (A) of Fig. 4, wherein (B) shows the molecular beam supply PR4 of the group III element starting materials (In-Ga); (C) shows the change of the molecular beam supply PR5 of the group V element (As) starting material; and (D) shows the change of the molecular beam supply PR6 of the group IV element (Si) starting material of the impurity element.

As shown in (C) of Fig. 7, first the group V starting material is fed to cover the surface of the base crystal 1 with the group V element (As). At the time t=to, the growth of the InGaAs is initiated by initiating the feeding of group III starting material, and at the time t=t₁₁, the feeding of the group V starting material is stopped. Only the group III starting material is fed onto the surface of the grown crystal, and on the growth surface there are generated vacancies (vacant lattice points) of the group V element.

The group IV element of the impurity element is fed at the time t=t,₂, and these group IV elements are trapped by the vacancies of the group V element and function as the p-type impurity.

The feeding of the group IV element (Si) of the impurity element is stopped at the time t=t₁₃, and instead, a feeding of the group III elements (In-Ga) starting material is recommenced. The feeding of the group III element causes, the exposed group III sites to be occupied.

The feeding of the group V elements is recommenced at the time t=t₁₄. That is, the group III elements and the group V element are fed between the time t=t₁₄ and the time t=t₁₅, and the III-V group compound semiconductor not doped with the impurity is grown.

The feeding of the group V element starting material is stopped at the time t=t₁₅, and only the group III starting materials are fed. Therefore, the growth surface is occupied by the group III elements, whereby a large number of vacancies of the group V element are generated. At the time t=t,₆, the group IV (Si) starting material of the impurity element is fed to occupy the vacancies of the group V element, and therefore, the impurity of the group IV element functions as the p-type impurity. The feeding of the group IV starting material of the impurity element is stopped at the time t=tₗ₇, and the group III starting materials again fed.

Thus, an undoped layer is formed by feeding the group III starting material and the group V starting material, vacancies of the group V element are formed by feeding only the group III starting material, and the group IV element is fed to occupy the group V element sites so that the group IV element functions as the acceptor. By repeating this operation, the layers not formed with the p-type impurity and the layers formed with the p-type impurity are alternately grown, and therefore, those layers act equivalently as the layer doped with the p-type impurity as a whole. For this purpose, the thickness of the layers 2a, 2b, 2c not doped with the p-type impurity should be restricted to a value of not more than that which permits a tunneling of the carriers.

In the embodiment described above, disilane (Si₂Hs) was employed as the impurity, but during the term when disilane was fed, since the feeding of at least one component of the compound semiconductor is stopped, the group III element, which is the impurity, is selectively fed to one of the group III element site and the group V element site, to function as the n-type impurity or the p-type impurity.

By alternately forming the doped layers and the layers due to the dopant sources, the layers formed by the gaseous dopant sources and the undoped layers are stably formed under constant conditions, and at the same time, by adequately controlling the ratio of both layers, the extent of the impurity doping as a whole can be controlled to a desired value.

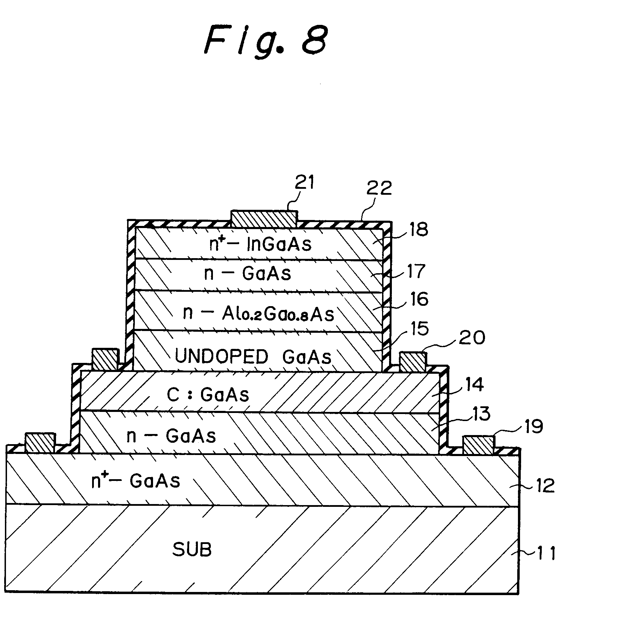

Figure 8 shows an example in which a bipolar transitor with a heterostructure is prepared by applying the method of the present invention.

In Fig. 8, 11 is a semi-insulating (100) GaAs substrate, 12 an n -GaAs collector contact layer (500 nm thickness), 13 an n-GaAs collector layer (400 nm thickness), 14 a carbon-doped p-GaAs base layer (92.5 nm thickness), 15 an undoped GaAs layer (7.5 nm thickness), 16 an n-Alₒ.₂Gaₒ.₈As emitter layer (150 nm thickness), 17 an n-GaAs layer (230 nm thickness), 18 an n -InGaAs emitter contact layer (50 nm thickness), 19 a collector electrode, 20 a base electrode, 21 an emitter electrode, and 22 an Si0₂ insulating layer.

Among these layers, those which were made multi-layer planar doped layers are the n -GaAs collector contact layer 12, the n-GaAs collector layer 13, the n-AIGaAs emitter layer 16, the n-GaAs layer 17, the n -InGaAs emitter contact layer 18. For the Ga source, triethylgallium (TEG) was employed; arsine (AsH₃) was used for the As source; triethylaluminum (TEAL) was used for the AI source; triethylindium (TEIn) was used for the In source; and disilane (Si₂H₆) was used for the doped impurity source. In all of the layers, the thickness of the layer due to the Si dopant source was made 3 nm, and the undoped layer thickness was 35 nm for the n -GaAs collector contact layer 12, 100 nm for the n-GaAs collector layer 13, 55 nm for the n-AIGaAs emitter layer 16, 50 nm for the n-GaAs layer 17, and 100 nm for the n -InGaAs emitter contact layer. Thus, the doped amount was made 3 x 10¹⁸ cm-³ in the n⁺-GaAs collector contact layer ₁₂, ₁ x 10¹⁷ cm-³ in the n-GaAs collector layer 13, 9 x 10¹⁷ cm-³ in the n-AIGaAs emitter layer 16, 2 x 10¹⁸ cm-³ in the n-GaAs layer 17, and 3 x 10¹⁹ cm-³ in the n⁺-InGaAs layer 18.

The p-GaAs base layer 14 was prepared at a TMG flow rate of 66.0mTorr, a AsH₃ flow rate of 3 sccm, with a carbon doping with an increased amount of TMG (III/V ratio). The doped amount was made 4 x 10¹⁹ cm-³. One of the advantages of the GSMBE method is the utilizability of the carbon doping method, and in the case of carbon doping, the impurity doping source is identical to the compound semiconductor source, and therefore, a different, ie. seponace carbon source does not have to be used.

The present invention is described above by reference to embodiments, but is not limited to these embodiments. For example, it would be obvious to those skilled in the art that various chnges, improvements, and combinations, etc., can be made.

As described above, according to the present invention, by alternately growing the undoped layers and the layers formed due to the gaseous impurity dopants, an epitaxial growth can be controlled with a high precision and a layer capable of functioning as a whole as a layer doped with the impurity can be grown with a high precision.

When forming the dopant impurity layer, by stopping the feeding of at least one component of the compound semiconductor, the site occupied by the impurity element can be selectively determined.

## Claims

1. A method of epitaxially growing a compound semiconductor layer of a substrate by gas source molecular beam epitaxy (GSMBE), comprising the steps of
growing a first layer of a compound semiconductor by supplying gas sources for elements of the compound semiconductor in a vacuum atmosphere without doping an impurity in said first layer,
forming a second layer containing an impurity by supplying said gas sources and a gas source for said impurity, but stopping at least one source of said gas sources to stop the growing of said compound semiconductor, in a vacuum atmosphere,
repeating the formation of said first and second layers to thereby form layers which function as an equivalent of a single impurity-doped compound semiconductor layer.

2. A method of epitaxially growing a III-V compound semiconductor layer on a substrate by gas source molecular beam epitaxy (GSMBE), comprising the steps of
growing a first layer of a III-V compound semiconductor by supplying gas sources for III and V group elements of the compound semiconductor in a vacuum atmosphere without doping an impurity in said first layer,
forming a second layer containing an impurity by supplying said gas sources for V group elements and a gas source for said impurity, but stopping said gas sources for III group elements to stop the growing of said compound semiconductor, in a vacuum atmosphere,
repeating the formation of said first and second layers to thereby form layers which function as an equivalent of a single n-type impurity-doped III-V compound semiconductor layer.

3. A method according to claim 2, wherein said gas source for the doping impurity is silane or disilane.

4. A method according to claim 2, wherein said gas sources are a metalorganic compound or a metal hydride.

5. A method according to claim 2, wherein said compound semiconductor is composed of not less than three elements.

6. A method according to claim 2, wherein said first layer has a thickness of up to 100 nm.

7. A method according to claim 6, wherein said first layer has a thickness of up to 50 nm.

8. A method according to claim 2, wherein said second layer has a thickness of at least 3 nm and less than that of said first layer.

9. A method according to claim 2, wherein said impurity-doped III-V compound semiconductor layer as a whole has a carrier concentration of more than ^{5 x 1018} cm-3.

10. A method according to claim 2, wherein said impurity-doped III-V compound semiconductor layer as a whole has a carrier concentration of more than 5 x 10¹⁸ cm-³ and a doping efficiency of more than 90%.

11. A method according to claim 2, wherein said vacuum atmosphere is on an order of 10-³ to 10-⁴ torr.

12. A process for manufacturing a semiconductor device, comprising a step of forming a doped semiconductor layer according to claim 1.

13. A process according to claim 12, wherein said semiconductor layer is a bipolar transistor and said doped compound semiconductor is an emitter.
